# FASCICULE DE BREVET EUROPEEN

(11) **EP 2 332 171 B1**
(45) Date de publication et mention de la délivrance du brevet: **01.07.2020**
(21) Numéro de dépôt: 09806435.5
(22) Date de dépôt: 13.08.2009
(51) Int. Cl.: H01L 21/762

(54) **PROCEDE DE FABRICATION D'UNE STRUCTURE SEMI-CONDUCTRICE PLAN DE MASSE ENTERRE**
VERFAHREN ZUR HERSTELLUNG EINER HALBLEITERSTRUKTUR MIT VERGRABENER BODENEBENE
PROCESS FOR FABRICATING A SEMICONDUCTOR STRUCTURE WITH A BURIED GROUND PLANE

(30) Priorité: 14.08.2008 FR 0855587
(43) Date de publication de la demande: 15.06.2011
(73) Titulaire: Commissariat à l'Énergie Atomique et aux Énergies Alternatives, 75015 Paris (FR)
(72) Inventeur: LE TIEC, Yannick, F-38920 Crolles (FR); ANDRIEU, François, F-38000 Grenoble (FR)
(74) Mandataire: Ilgart, Jean-Christophe
(86) Numéro de dépôt international: PCT/EP2009/060474
(87) Numéro de publication internationale: WO 2010/018204

(56) Documents cités:
- WO-A-03/103026
- FR-A- 2 898 430
- JP-A- H11 111 839
- US-A1- 2006 019 465
- US-A1- 2008 153 313
- US-B1- 6 323 108

## Description

### DOMAINE TECHNIQUE ET ART ANTÉRIEUR

L'invention concerne la réalisation de nouvelles structures pour des composants semi-conducteurs, et notamment de structures SOI (silicium sur isolant) ou plus généralement semi-conducteur sur isolant.

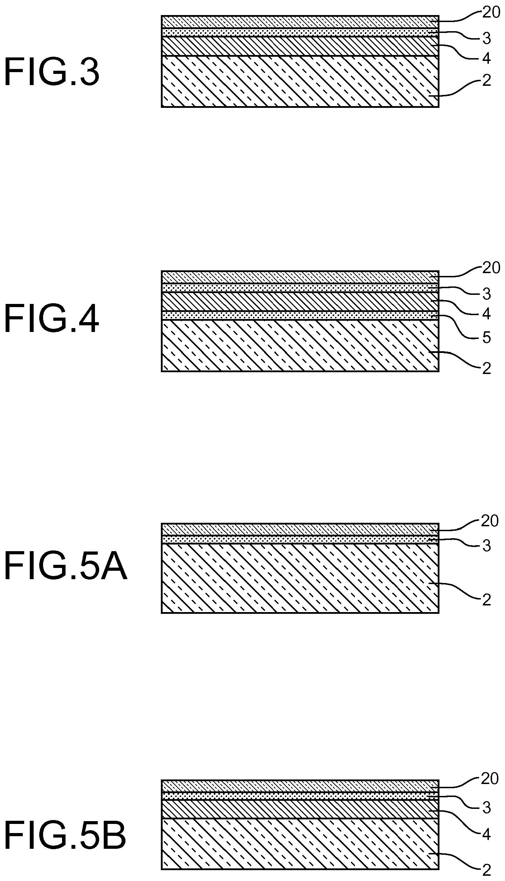

Comme illustré sur la figure 5A, les structures du type SOI (et plus généralement semi-conducteur sur isolant) sont des empilements composés d'un film superficiel 20 en silicium monocristallin (respectivement en matériau semi-conducteur), d'une couche diélectrique 3, en général en oxyde de silicium et d'un substrat support 2, par exemple en silicium. Ces structures de type SOI sont obtenues par exemple par assemblage par adhésion moléculaire d'une plaque de silicium oxydée en surface, avec une autre plaque de silicium, puis amincissement du premier substrat.

De manière plus précise l'assemblage comprend une étape de préparation de surface des deux plaques, une étape de mise en contact et une étape de traitement thermique. De façon classique ce traitement thermique est réalisé à des températures comprises entre, typiquement, 900° et 1250°C durant 2h.

Ensuite, au moins une des deux plaques est amincie, laissant subsister une couche mince 20 semi-conductrice sur une couche diélectrique 3.

L'amincissement a lieu par différents moyens mécaniques, ou chimiques, ou par séparation au niveau d'une couche enterrée fragilisée par exemple par implantation d'espèces gazeuses (par exemple d'hydrogène).

Pour certaines applications, il est intéressant d'obtenir des circuits sur un plan de masse conducteur 4 (figure 5B).

Pour cela, on cherche à ce que l'ensemble constitué par la couche semi-conductrice superficielle 20 et la couche diélectrique 3 enterrée soit disposé sur une couche conductrice électriquement, ou plan de masse (figure 5B). Ainsi il est possible de contrôler la densité des porteurs dans la couche du semi-conducteur au voisinage de l'interface par l'intermédiaire de la différence de potentiel appliquée à la couche conductrice enterrée et à la couche semi-conductrice.

Or, il est difficile d'obtenir des plaques SOI avec une couche diélectrique 3 de faible épaisseur, par exemple inférieure à 150 nm, et un plan de masse.

Une des méthodes utilisée par les utilisateurs de substrats de type SOI est l'implantation ionique du substrat SOI final à travers le film 20 et la couche isolante électriquement 3 pour doper le matériau semi-conducteur du substrat de façon à obtenir une couche de matériau conducteur situé à l'interface entre la couche diélectrique et le substrat final.

Idéalement, pour avoir un plan de masse, il faut implanter le substrat, à travers le film surfacique 20 et la couche 3 d'isolant, de façon à avoir un dopage supérieur à 10¹⁹ at.cm⁻³, de préférence supérieur à 10²⁰ at.cm⁻³, par exemple 10²¹ at.cm⁻³. Cependant, l'obtention de cet optimum pose un problème, car l'usage d'une implantation ionique assez considérable (de l'ordre de 10¹⁶ at.cm⁻² ou 10¹⁵ at.cm⁻²), pour obtenir un tel dopage sous la couche 3 d'oxyde, conduit à une dégradation des couches traversées, c'est-à-dire à un dopage et une dégradation de la couche semi-conductrice superficielle 20 et de la couche isolante électriquement 3. Ceci a un impact sur les performances de la couche superficielle, dans laquelle doivent être réalisés des composants, par exemple des transistors (cette couche peut notamment servir de canal à des transistors). Pour pallier ce phénomène, il est courant que les doses d'implantation soient réduites, pour obtenir au final un dopage proche de 10¹⁸ at.cm⁻³, inférieur aux conditions optimales. Cette implantation sous-dosée limite (mais n'élimine pas) les dégradations de la couche 20.

Le document JP H11 111839 A se rapporte à la fabrication d'un substrat SOI avec une couche active mince et une couche de plan de masse.

Il se pose donc le problème de réaliser un structure semi-conductrice de type SOI possédant un plan de masse entre la couche diélectrique et le substrat final, les deux couches supérieures, couche superficielle en matériau semi-conducteur et couche diélectrique n'étant pas dégradées par la formation de ce plan de masse.

Il se pose également le problème d'atteindre les dopages optimaux pour la formation du plan de masse.

### EXPOSÉ DE L'INVENTION

L'invention concerne tout d'abord un procédé de réalisation d'une structure semi-conductrice sur isolant, tel que défini dans la revendication 1, comprenant :
a) la formation à la surface d'un substrat semi-conducteur, dit substrat final, d'une couche semi-conductrice, dopée à au moins 10¹⁸ at.cm⁻³ avec des éléments des colonnes III et/ou V du tableau de Mendeleïev de façon à former un plan de masse,
b) puis l'assemblage d'un substrat semi-conducteur, dit substrat source, soit en matériau semi-conducteur, soit comportant au moins en surface un film semi-conducteur, sur ou avec le substrat final, la couche de plan de masse étant comprise entre le substrat final et le substrat source, et au moins une couche diélectrique étant formée sur le substrat final, par-dessus le plan de masse, et/ou sur le substrat source avant l'assemblage,
c) puis l'amincissement partiel du substrat source, laissant, à la surface de la structure semi-conductrice, au moins une partie du film semi-conducteur présent à la surface du substrat source.

L'élément de dopage, servant à former la couche de plan de masse, est choisi parmi le bore (B), l'arsenic (As), le phosphore (P), l'azote (N), l'antimoine (Sb), l'aluminium (Al), le gallium (Ga), l'indium (In).

Dans un procédé selon l'invention, on forme, préalablement à l'assemblage du substrat source et du substrat final, un plan de masse en matériau semi-conducteur dopé en éléments des colonnes III ou V du tableau de Mendeleïev, le dopage dans cette couche étant de préférence supérieur à 5.10¹⁸ at.cm⁻³, préférentiellement supérieur à 10¹⁹ at.cm⁻³ et avantageusement supérieur à 10²⁰ at.cm⁻³, par exemple 10²¹ at.cm⁻³.

Puis, on réalise moins une couche isolante électriquement sur l'un des deux substrats.

Puis on assemble les deux substrats par collage moléculaire, la couche de plan de masse et la couche diélectrique étant alors comprises entre les deux substrats.

Puis on réalise un amincissement partiel du substrat source de façon à obtenir un film en matériau semi-conducteur au dessus de la couche diélectrique, du plan de masse et du substrat final.

L'étape de dopage pour former le plan de masse, réalisée avant l'étape d'assemblage et la formation du film superficiel de matériau semi-conducteur (destiné à être utilisée pour, par exemple, y former tout ou partie de transistors) ne risque pas d'endommager ledit film superficiel.

Le dopage dans le plan de masse peut être de type « p » ou de type « n » et est avantageusement supérieur de 10¹⁹ at.cm⁻³ et potentiellement supérieur de 10²⁰ at.cm⁻³.

Le plan de masse peut être formé par implantation ionique de la surface du substrat final. Cette implantation ionique peut se faire à travers une couche superficielle, par exemple en oxyde, déposée avant implantation et qui peut être éliminée après l'implantation.

Dans une variante, le plan de masse peut être formé par dépôt par épitaxie ou CVD ou MBE ou par un autre procédé de dépôt d'une couche semi-conductrice dopée.

La couche diélectrique peut être formée par réaction à la surface du substrat source, par exemple par oxydation ou nitruration, ou par dépôt sur le substrat source ou sur le plan de masse.

Dans une variante, au moins l'une des faces à assembler subit avant assemblage une nitruration de surface, par exemple par traitement plasma

Selon l'invention, précédant la formation du plan de masse, une couche de barrière à la diffusion est déposée sur le substrat final, la couche barrière étant alors positionnée entre le substrat final et le plan de masse.

Le substrat source peut avoir subi une implantation localisée en profondeur d'espèces gazeuses, préférentiellement de l'hydrogène, pour former une couche enterrée fragilisée. Dans ce cas-là, l'amincissement partiel du substrat source peut se faire selon un procédé de fracture de substrat de type « Smart-Cut™ », décrit plus bas, suivi éventuellement d'un polissage.

Selon un autre mode de réalisation d'un procédé selon l'invention, l'amincissement partiel du substrat source peut être réalisé par meulage et/ou polissage chimique, ou mécanique, ou mécanochimique, et/ou par gravure chimique. Dans ce cas, il n'y a pas eu d'implantation préalable dans le substrat source.

L'invention concerne aussi un dispositif de couches semi-conductrices superposées, tel que défini dans la revendication 12, comportant dans l'ordre :
a) un substrat dit substrat final,
b) une couche semi-conductrice, dopée avec des éléments des colonnes III et V du tableau de Mendeleïev, formant plan de masse, positionnée au-dessus du substrat, avec une concentration en dopant supérieure à 10¹⁸ at.cm⁻³, ou supérieure à 10¹⁹ at.cm⁻³ ou même à 10²⁰ at.cm⁻³,
c) au moins une couche de matériau diélectrique, le plan de masse étant compris entre la couche diélectrique et le substrat final, la couche diélectrique étant présente entre le film semi-conducteur superficiel et le plan de masse,
d) un film en matériau semi-conducteur, au-dessus de la couche diélectrique, du plan de masse et du substrat final.

Dans le procédé selon l'invention, le substrat final a été recouvert, avant dépôt de la couche de plan de masse, d'une couche de matériau barrière à la diffusion en carbure de silicium. Cette couche étant présente, après assemblage, entre le substrat final et le plan de masse.

Dans un procédé ou un dispositif selon l'invention, le substrat final et/ou le substrat source peuvent être en silicium, ou en SiC, ou en SiGe, ou en Ge, ou en GaN....

### BRÈVE DESCRIPTION DES DESSINS

- La figure 1 représente un exemple de procédé qui ne fait pas partie de l'invention telle que revendiquée,
- La figure 2 représente un mode préférentiel de réalisation de procédé selon l'invention,
- La figure 3 représente un exemple de dispositif qui ne fait pas partie de l'invention telle que revendiquée,
- La figure 4 représente un mode préférentiel de réalisation de dispositif selon l'invention, et
- les figures 5A et 5B représentent des dispositifs de type SOI, sans et avec plan de masse.

### EXPOSÉ DÉTAILLÉ DE MODES DE RÉALISATION PARTICULIERS

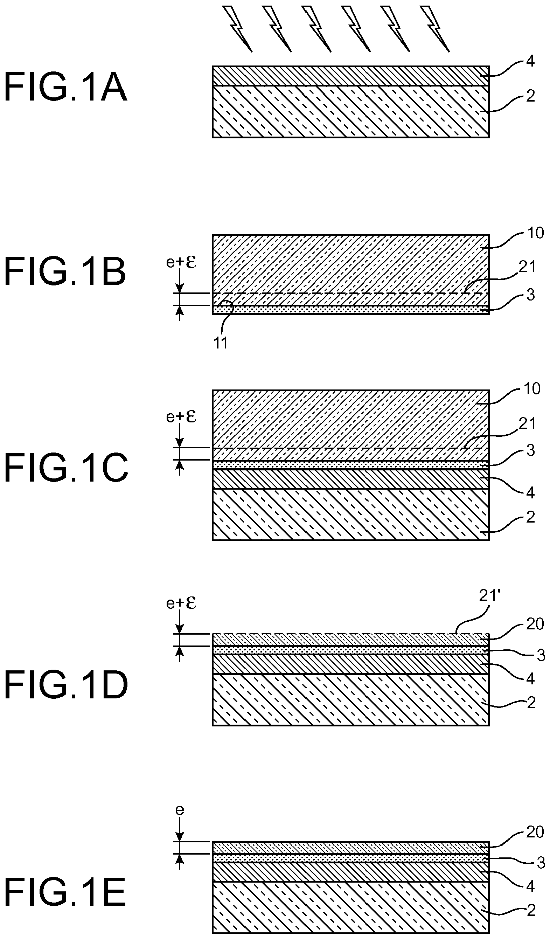

Des modes de réalisation de l'invention sont détaillés ci-dessous, illustrés par les figures 1 à 2 dans lesquelles les références des différents éléments sont communes aux différentes figures.

Un procédé de base est décrit avec les figures 1A à 1E.

En premier lieu, la surface 12 d'un substrat 2 en matériau semi-conducteur, ou d'un substrat 2 présentant au moins en surface une couche en matériau semi-conducteur, en silicium ou en carbure de silicium par exemple, est soumise à une implantation ionique (figure 1A) de façon à doper le volume surfacique 4 en éléments des colonnes III ou V du tableau de Mendeleïev de façon à former un plan de masse, c'est-à-dire à rendre cette couche dopée 4 au moins partiellement conductrice. Les dopants peuvent être introduits dans le substrat semi-conducteur autrement que par implantation, par exemple un dopage plasma ou un dopage CVD.

Le dopage dans cette couche 4 est supérieur à 10¹⁸ at.cm⁻³ ou à 5.10¹⁸ at.cm⁻³ , il est préférentiellement supérieur à 10¹⁹ at.cm⁻³ et avantageusement supérieur à 10²⁰ at.cm⁻³ et peut ainsi former soit un semi-conducteur dopé « n », soit un semi-conducteur dopé « p ».

Le substrat 2, et donc le plan de masse, est par exemple à base de silicium. Avantageusement pour une couche semi-conductrice en silicium ou en Si_{99%}(C)_{1%}, ou comportant au moins une couche superficielle en un desdits matériaux, on choisira les dopants parmi le bore (B), l'arsenic (As), le phosphore (P), l'antimoine (Sb), le gallium (Ga), l'indium (In). Pour une couche semi-conductrice en SiC, on préférera l'azote (N) ou l'aluminium (Al). Cette étape de dopage ne traverse aucune couche devant par la suite être utilisée pour former tout ou partie de composants électroniques. Elle ne peut donc endommager une telle couche.

Le dopage par implantation peut se faire à travers une couche superficielle, par exemple un masque en oxyde. Ce masque est alors déposé juste avant l'étape d'implantation et est de préférence retiré juste après cette étape.

Alternativement, le plan de masse 4 peut être formé par dépôt sur le substrat 2, par technique CVD, ou par épitaxie, ou par croissance par jet moléculaire... etc. Dans ce cas encore, il n'y a aucune atteinte à la future couche mince de matériau semi-conducteur 20.

Sur un deuxième substrat 10, dit substrat source, est éventuellement formée une couche diélectrique 3 (figure 1B). Cette couche est par exemple en oxyde (SiO2 par exemple), et/ou en nitrure (SixNy) et/ou en matériau high K (comme HfO2, Al2O3, HfSiON...). Cette couche 3 peut avoir été formée par dépôt ou par oxydation ou nitruration de la surface du substrat source 10. Cette couche 3 peut être alternativement déposée par-dessus la couche de plan de masse 4, sur le substrat 2.

Une implantation localisée 21 d'espèces gazeuses, à une profondeur **e+ε** sous la couche diélectrique 3 (ou sous la surface 11 du substrat source 10 si il n'y a pas de couche diélectrique ou si celle-ci est réalisée après implantation), peut ensuite être effectuée en prévision d'un amincissement par fracture de substrat. Dans la suite, on fait mention du procédé de fracture de substrat « Smart Cut™ ». Ce procédé est décrit par exemple dans l'article de B. Aspar et A.J. Auberton-Hervé « Silicon Wafer Bonding Technology for VLSI and MEMS applications », edited by S.S. Iyer and A.J. Auberton-Hervé, 2002, INSPEC, London, Chapter 3, pages 35-52. L'espèce implantée est avantageusement de l'hydrogène. En variante, il peut s'agir d'hélium ou d'un gaz rare ou d'une combinaison de ces espèces.

Ensuite, les deux substrats 2 et 10, sont assemblés par collage moléculaire, par les surfaces libres (figure 1C). Ces surfaces libres sont celles permettant d'obtenir un empilement de couches minces comprenant un substrat source 10, une couche diélectrique 3 en contact avec le substrat 10, une couche conductrice 4 à base de matériau semi-conducteur, formant plan de masse, comprise entre la couche isolante 3 et le substrat final 2. Dans les cas des figures 1B et 1C, les surfaces libres sont les celles du plan de masse 4 et de la couche diélectrique 3.

Ce collage moléculaire peut par exemple être réalisé entre surfaces hydrophiles. Pour cela, les surfaces sont alors préalablement préparées selon des techniques connues de l'homme du métier (nettoyage chimique, CMP, activation plasma, traitement UV Ozone...) avant d'être mises en contact.

Dans une variante, la couche diélectrique étant formée sur le substrat 10 et le plan de masse 4 étant formé sur le substrat 2, le plan de masse 4 peut être recouvert avant collage d'une couche diélectrique, en oxyde (SiO2 par exemple), et/ou en nitrure (SixNy) et/ou en matériau high K (comme HfO2, Al2O3, HfSiON...) .

Il est possible également avant assemblage de nitrurer au moins l'une des deux faces à assembler par exemple par traitement plasma.

On amincit ensuite la face arrière du substrat source 10 de façon à ne laisser qu'un film 20, d'épaisseur **e,** en matériau semi-conducteur (figure 1D). Cette étape d'amincissement est réalisée, par exemple, par fracture du substrat source **10** au niveau de la zone fragile préalablement crée à la profondeur **e+ε**, suivie d'un polissage de la surface 21' formée de façon à obtenir le film 20, d'épaisseur **e,** à la surface de la structure semi-conductrice de type SOI (figure 1E).

En variante l'amincissement partiel du substrat source 10 peut être réalisé par meulage et/ou polissage et/ou gravure chimique. Dans ce cas, il n'y a pas de formation préalable d'une zone 21 de fragilisation dans le substrat donneur 10.

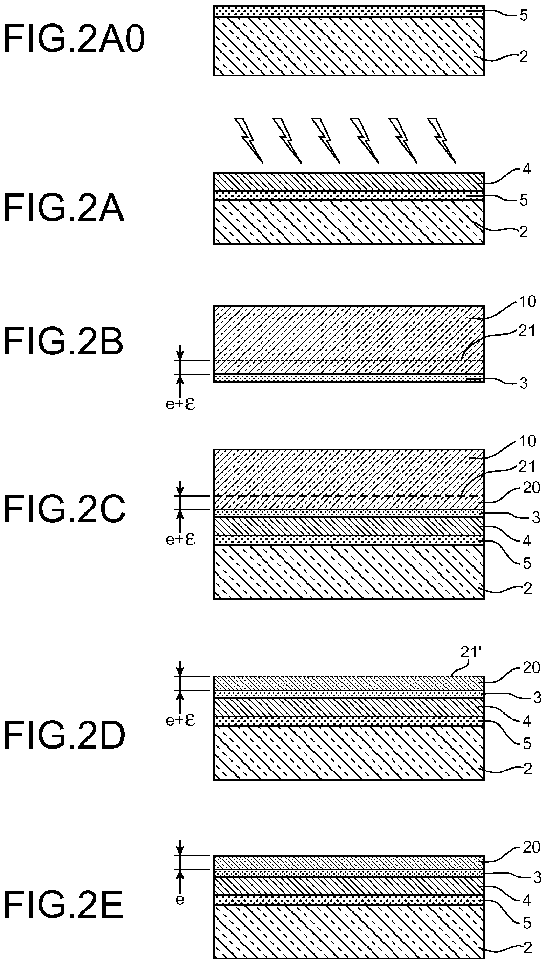

L'exemple de procédé selon l'invention va être décrit en liaison avec les figures 2A0 et 2A à 2E.

Les étapes mises en œuvre sont identiques à celles décrites en liaison avec les figures 1A à 1E, hormis pour la figure 2A0 qui représente une étape antérieure à l'étape de la figure 2A.

On se reportera donc à la description précédente à laquelle se rajoute la description de la figure 2A0 ci-dessous.

Une couche barrière 5 est déposée sur le substrat 2 avant formation du plan de masse 4 sur ce même substrat (figure 2A0). Cette couche sert de barrière à la diffusion pour limiter, et avantageusement bloquer, la diffusion des espèces dopantes dans le substrat final 2, afin de préserver la qualité de la conductivité du plan de masse. Cette couche barrière est en carbure de silicium, par exemple en Si_{99%}(C)_{1%} lorsqu'il s'agit de limiter la diffusion de bore par exemple. Après assemblage, cette couche barrière 5 se trouve donc entre le plan de masse 4 et le substrat final 2.

Par-dessus cette couche barrière est formée la couche de plan de masse 4 (figure 2A), par exemple par dépôt d'une couche semi-conductrice suivie d'un dopage par implantation de cette couche tel que décrit précédemment, ou par dépôt d'une couche semi-conductrice dopée par les moyens décrits dans le premier mode de réalisation.

Là encore, l'amincissement partiel du substrat source 10 peut être réalisé soit par fracture le long d'une zone de fragilisation réalisée dans ce substrat, comme décrit dans le premier exemple, soit par meulage et/ou par polissage et/ou gravure chimique.

L'invention couvre toutes les combinaisons des deux modes de réalisation décrits précédemment, en particulier ceux résultant de variantes concernant la formation du plan de masse, et le procédé d'amincissement.

Les procédés décrits ci-dessus permettent d'obtenir un dispositif semi-conducteur comportant :
- un substrat,
- une couche superficielle de matériau semi-conducteur,
- au moins une couche enterrée en matériau diélectrique entre le film superficiel et le substrat final,
- au moins un plan de masse entre cette couche diélectrique et le substrat
- et une couche de barrière de diffusion, entre le plan de masse et le substrat final.

Dans tous les cas, la couche superficielle est intacte, elle n'a pas été traversée par un faisceau d'implantation d'éléments en vue de former le plan de masse, puisque celui-ci est formé avant l'étape d'assemblage.

L'invention concerne également concerne également un dispositif semi-conducteur de couches superposées ayant une des structures illustrées sur la figure 4.

Un tel dispositif comporte un substrat 2.

Sur ce substrat 2 se trouve une couche semi-conductrice 4, dopée avec des éléments des colonnes III et V du tableau de Mendeleïev, formant plan de masse, le dopage dans cette couche étant supérieur à 10¹⁸ at.cm⁻³, préférentiellement supérieure à 10¹⁹ at.cm⁻³, et avantageusement supérieure à 10²¹ at.cm⁻³.

Ce dispositif comporte en outre au moins un film 20 en matériau semi-conducteur, ainsi qu'une couche en matériau diélectrique 3, le plan de masse 4 étant compris entre la couche 3 et le substrat final 2, la couche 3 étant comprise entre le plan de masse 4 et le film superficiel 20.

Ce dispositif comporte en outre une couche 5 de matériau formant barrière de diffusion en carbure de silicium, par exemple en Si_{99%}(C)_{1%}, pouvant être située entre le plan de masse 4 et substrat 2 (figure 4) L'épaisseur de cette couche barrière est comprise entre 2 nm et 50 nm, par exemple 10 nm.

Dans un procédé ou dispositif selon l'invention :
- le substrat dit final 2 et le substrat donneur 10 peuvent être massifs en matériau semi-conducteur par exemple en silicium ou en SiC, ou composites et comporter en surface au moins une couche mince semi-conductrice, par exemple en silicium ou en carbure de silicium ou en SiGe ou en germanium ou en GaN...,
- la couche diélectrique est, par exemple, constituée d'un ou plusieurs matériaux choisis parmi les oxydes (SiO2 par exemple), les nitrure (SixNy par exemple), les matériaux high K (comme HfO₂, Al₂O₃, HfSiON...) . L'épaisseur totale de cette couche diélectrique est de préférence comprise entre 2 nm et 150 nm et avantageusement entre 2 nm et 25 nm,
- le plan de masse a, de préférence, une épaisseur comprise entre 5 nm et 100 nm, avantageusement entre 5 nm et 10 nm. En effet, l'épaisseur de cette couche est choisie de façon à être suffisamment fine pour limiter les phénomènes de capacités parasites et être suffisamment épaisse pour assurer une bonne conduction latérale et limiter les phénomènes de diffusion du dopant hors de cette couche.

Le film semi-conducteur d'un dispositif selon l'invention, et le film conducteur d'un dispositif obtenu en fin de procédé peut avoir, une épaisseur **e** comprise entre 2 nm et 100 nm, et avantageusement comprise entre 2 nm et 20 nm pour les applications nécessitant un film superficiel 20 en matériau semi-conducteur totalement déplété (FD fully depleted)

Les dispositifs semi-conducteurs de couches superposées décrits précédemment et les dispositifs obtenus par les procédés selon l'invention peuvent être introduits dans toute ligne de production. Il est ainsi possible de fabriquer sur ce dispositif des composants microélectroniques tels que des circuits intégrés, et/ou des capteurs MEMS, et/ou des composants optiques (MOEMS) et/ou des biocomposant et/ou des commutateurs. Par exemple, le film supérieur 20 peut ainsi recevoir, ultérieurement au procédé selon l'invention, divers types d'implantations totales ou localisées, de façon à le doper et à permettre la fabrication de composants électroniques, par exemple des transistors. Compte tenu de son procédé de réalisation, ce film 20 est intact et n'a subi aucune dégradation.

## Revendications

1. Procédé de réalisation d'une structure semi-conductrice, comportant :
a) la formation à la surface d'un substrat semi-conducteur (2), dit substrat final, d'une couche semi-conductrice (4), dopée à au moins 10¹⁸ atomes.cm⁻³ avec des éléments des colonnes III et/ou V du tableau de Mendeleïev, formant plan de masse,
b) la formation d'une couche diélectrique (3) :
- soit sur une surface en matériau semi-conducteur d'un deuxième substrat (10) dit substrat source, qui est en matériau semi-conducteur ou qui comporte une couche superficielle en matériau semi-conducteur,
- soit sur le substrat final et en contact avec le plan de masse,
c) puis l'assemblage par collage direct du substrat source, sur le substrat final (2), la couche (4) formant plan de masse étant comprise entre le substrat final et le substrat source, la couche diélectrique étant entre le substrat source et le plan de masse,
d) puis l'amincissement du substrat source, laissant, à la surface de la structure semi-conductrice, un film (20) en matériau semi-conducteur, procédé dans lequel on dépose, sur le substrat (2), avant la réalisation du plan de masse, une couche (5) de barrière à la diffusion en carbure de silicium.

2. Procédé selon la revendication 1, la couche barrière à la diffusion étant de type Si_{99%}(C _{1%}.

3. Procédé selon l'une des revendications 1 ou 2, la couche diélectrique (3) étant en oxyde et/ou en nitrure et/ou en matériau high K.

4. Procédé selon l'une des revendications 1 à 3, la couche diélectrique (3) étant formée par réaction et/ou par dépôt sur au moins l'une des faces à assembler.

5. Procédé selon l'une des revendications 1 à 4, le substrat final et/ou le substrat source étant en silicium ou en carbure de silicium Si₍₁₋ₓ₎(Cₓ.

6. Procédé selon l'une des revendications 1 à 5, le plan de masse (4) étant :
- formé par dépôt d'une couche dopée, par exemple par dépôt par épitaxie ou CVD ou MBE ou par un autre procédé de dépôt ;
- ou par implantation ionique ou dopage plasma ou dopage CVD à la surface du substrat final (2) ;
- ou par implantation ionique à travers une couche superficielle, déposée avant implantation et éliminée après l'implantation.

7. Procédé selon l'une des revendications 1 à 6, le dopage dans le plan de masse étant supérieur à 10¹⁹ atomes.cm⁻³ ou à 10²⁰ atomes.cm⁻³.

8. Procédé selon une des revendications 1 à 7, l'une au moins des faces à assembler étant nitrurée avant collage.

9. Procédé selon l'une des revendications 1 à 8, le substrat source (10) ayant subit une implantation d'espèces gazeuses, par exemple de l'hydrogène, localisée sous la surface, pour y former une zone enterrée (21) de fragilisation, cette opération pouvant avoir lieu avant ou après la formation de la couche diélectrique (3).

10. Procédé selon la revendication 9, l'amincissement du substrat source (10) se faisant selon un procédé de fracture de substrat au niveau de la zone enterrée de fragilisation (21).

11. Procédé selon l'une des revendications 1 à 8, l'amincissement du substrat se faisant par meulage, et/ou amincissement mécanique, et/ou mécanochimique, et/ou par gravure chimique.

12. Dispositif de couches semi-conductrices superposées, comportant :
a) un substrat (2),
b) une couche (5) de matériau barrière à la diffusion, en carbure de silicium,
c) une couche semi-conductrice (4), dopée à au moins 10¹⁸ atomes.cm⁻³ avec des éléments des colonnes III et/ou V du tableau de Mendeleïev, formant plan de masse, positionnée au dessus du substrat, la couche (5) de matériau barrière à la diffusion étant située entre le plan de masse (4) et le substrat (2),
d) une couche diélectrique (3) disposée par-dessus la couche de plan de masse,
e) un film (20) en matériau semi-conducteur, d'épaisseur comprise entre 2 nm et 100 nm, au-dessus de la couche diélectrique, la couche diélectrique étant comprise entre ce film et le plan de masse.

13. Dispositif selon la revendication 12, la couche semi-conductrice (4) formant plan de masse étant dopée avec une concentration en dopant supérieure à 10¹⁹ atomes.cm³, ou supérieure 10²⁰ atomes.cm⁻³.

14. Dispositif selon l'une des revendications 12 ou 13, la couche (5) de matériau barrière à la diffusion étant en Si_{99%}(C_{1%}.

## Patentansprüche

1. Verfahren zur Herstellung einer Halbleiterstruktur, umfassend:
a) Ausbilden einer Halbleiterschicht (4) auf der Oberfläche eines Halbleitersubstrats (2), Endsubstrat genannt, welche Halbleiterschicht (4) zu zumindest 10¹⁸ Atom.cm⁻³ mit Elementen aus den Spalten III und/oder V des Periodensystems der Elemente dotiert ist und eine Masseebene bildet,
b) Ausbilden einer dielektrischen Schicht (3):
- entweder auf einer Halbleitermaterialoberfläche eines zweiten Substrats (10), Quellensubstrat genannt, das aus Halbleitermaterial besteht oder eine Oberflächenschicht aus Halbleitermaterial aufweist,
- oder auf dem Endsubstrat und in Kontakt mit der Masseebene,
c) dann Verbinden durch direktes Aufkleben des Quellensubstrats auf das Endsubstrat (2), wobei die die Masseebene bildende Schicht (4) zwischen dem Endsubstrat und dem Quellensubstrat liegt und die dielektrische Schicht zwischen dem Quellensubstrat und der Masseebene liegt,
d) dann Verjüngen des Quellensubstrats, wobei ein Film (20) aus Halbleitermaterial an der Oberfläche der Halbleiterstruktur zurückbleibt,
wobei bei dem Verfahren eine Diffusionssperrschicht (5) aus Siliciumcarbid auf dem Substrat (2) abgeschieden wird, bevor die Masseebene ausgebildet wird.

2. Verfahren nach Anspruch 1,
wobei die Diffusionssperrschicht vom Typ Si_{99%}C_{1%} ist.

3. Verfahren nach einem der Ansprüche 1 oder 2,
wobei die dielektrische Schicht (3) aus Oxid und/oder Nitrid und/oder einem Material mit hohem K-Wert besteht.

4. Verfahren nach einem der Ansprüche 1 bis 3,
wobei die dielektrische Schicht (3) durch Reaktion und/oder Abscheidung auf mindestens einer der zu verbindenden Flächen ausgebildet wird.

5. Verfahren nach einem der Ansprüche 1 bis 4,
wobei das Endsubstrat und/oder das Quellensubstrat aus Silicium oder Siliciumcarbid Si₍₁₋ₓ₎ Cₓ besteht/bestehen.

6. Verfahren nach einem der Ansprüche 1 bis 5,
wobei die Masseebene (4)
- durch Abscheidung einer dotierten Schicht, beispielsweise durch Epitaxie- oder CVD- oder MBE-Abscheidung oder einen anderen Abscheidungsprozess gebildet wird;
- oder durch Ionenimplantation oder Plasma- oder CVD-Dotierung an der Oberfläche des Endsubstrats (2);
- oder durch Ionenimplantation durch eine Oberflächenschicht hindurch, die vor der Implantation abgeschieden und nach der Implantation entfernt wird.

7. Verfahren nach einem der Ansprüche 1 bis 6,
wobei die Dotierung in der Masseebene höher als 10¹⁹ Atom.cm⁻³ oder 10²⁰ Atom.cm⁻³ ist.

8. Verfahren nach einem der Ansprüche 1 bis 7,
wobei zumindest eine der zu verbindenden Flächen vor dem Verkleben nitriert wird.

9. Verfahren nach einem der Ansprüche 1 bis 8,
wobei das Quellensubstrat (10) einer Implantation von gasförmigen Spezies, beispielsweise Wasserstoff, unterzogen wird, die unter der Oberfläche liegt, um darin eine vergrabene Versprödungszone (21) zu bilden, wobei dieser Vorgang vor oder nach dem Ausbilden der dielektrischen Schicht (3) erfolgen kann.

10. Verfahren nach Anspruch 9,
wobei das Verjüngen des Quellensubstrats (10) durch einen Substratbrechvorgang im Bereich der vergrabenen Versprödungszone (21) erfolgt.

11. Verfahren nach einem der Ansprüche 1 bis 8,
wobei das Verjüngen des Substrats durch Schleifen und/oder mechanisches und/oder mechanisch-chemisches Verjüngen und/oder durch chemisches Ätzen erfolgt.

12. Vorrichtung aus übereinanderliegenden Halbleiterschichten, enthaltend:
a) ein Substrat (2),
b) eine Diffusionssperrschicht (5) aus Siliciumcarbid,
c) eine Halbleiterschicht (4), die zu mindestens 10¹⁸ Atom.cm⁻³ mit Elementen aus den Spalten III und/oder V des Periodensystems der Elemente dotiert ist und eine Masseebene bildet und über dem Substrat positioniert ist, wobei die Diffusionssperrschicht (5) zwischen der Masseebene (4) und dem Substrat (2) liegt,
d) eine dielektrischen Schicht (3), die über der Schicht der Masseebene angeordnet ist,
e) einen Film (20) aus Halbleitermaterial mit einer Dicke zwischen 2 nm und 100 nm über der dielektrischen Schicht, wobei die dielektrische Schicht zwischen diesem Film und der Masseebene enthalten ist.

13. Vorrichtung nach Anspruch 12,
wobei die die Masseebene bildende Halbleiterschicht (4) mit einer Konzentration an Dotierungsmittel von über 10¹⁹ Atom.cm⁻³ oder von über 10²⁰ Atom.cm⁻³ dotiert ist.

14. Vorrichtung nach einem der Ansprüche 12 oder 13,
wobei die Diffusionssperrschicht (5) aus Si_{99%}C_{1%} besteht.

## Claims

1. Method for making a semiconductor on insulator structure, comprising:
a) forming, on the surface of a semiconductor substrate (2), called the final substrate, a semiconducting layer (4), doped at a concentration greater than 10¹⁸ at.cm⁻³ with elements from columns III and/or V of the Periodic Table so as to form a ground plane,
b) forming a dielectric layer (3):
- either on a surface made from a semiconducting material of a second substrate (10), called the source substrate, which is made from a semiconducting material or includes a superficial layer made from a semiconducting material,
- or on the final substrate and in contact with the ground plane,
c) then assembling, by direct adhesion of the source substrate, on the final substrate (2), the layer (4) forming the ground plane being between the final substrate and the source substrate, the dielectric layer being between the source substrate and the ground plane,
d) then thinning the source substrate, leaving, on the surface of the semiconductor structure, a film (20) made from a semiconducting material,
method in which a layer (5) made from silicon carbide and acting as a barrier against diffusion is deposited on the substrate (2) before making the ground plane.

2. Method according to claim 2, the layer acting as a barrier against diffusion being of the Si_{99%}(C)_{1%} type.

3. Method according to any one of claims 1 or 2, the dielectric layer (3) being made from oxide and/or nitride and/or high K material.

4. Method according to one of claims 1 to 3, the dielectric layer (3) being formed by reaction and/or by deposition on at least one of the faces to be assembled.

5. Method according to one of claims 1 to 4, the final substrate and/or the source substrate being made from silicon or silicon carbide Si₍ᵢ₋ₓ₎(C)ₓ.

6. Method according to one of claims 1 to 5, the ground plane (4) being:
- formed by depositing a doped layer, for example be deposition by epitaxy or CVD or MBE or using another deposition method;
- or by ion implantation or plasma doping or CVD doping on the surface of the final substrate (2);
- or by ion implantation through a superficial layer, deposited before implantation and eliminated after implantation.

7. Method according to one of claims 1 to 6, the doping in the ground plane being greater than 10¹⁹ at.cm⁻³ or 10²⁰ at.cm⁻³.

8. Method according to one of claims 1 to 7, at least one of the faces to be assembled being nitrided before adhesion.

9. Method according to one of claims 1 to 8, the source substrate (10) having undergone an implantation of gaseous species, for example hydrogen, localized under the surface, to form a buried embrittlement zone (21) there, this operation being able to take place before or after formation of the dielectric layer (3).

10. Method according to claim 9, the thinning of the source substrate (10) occurring according to a substrate fracture method at the buried embrittlement zone (21).

11. Method according to one of claims 1 to 8, the thinning of the substrate occurring by milling, and/or mechanical thinning, and/or mechano-chemical thinning, and/or chemical etching.

12. Device with superimposed semiconducting layers, including:
a) a substrate (2),
b) a layer (5) of material acting as a barrier against diffusion, made from silicon carbide,
c) a semiconducting layer (4), doped at a concentration greater than 10¹⁸ at.cm⁻³ with elements from columns III and/or V of the Periodic Table, forming a ground plane, positioned above the substrate, the layer (5) of material acting as a barrier against diffusion being between the ground plane (4) and the substrate (2),
d) a dielectric layer (3) arranged above the ground plane layer,
e) a film (20) made from semiconducting material, with a thickness between 2 nm and 100 nm, above the dielectric layer, the dielectric layer being between said film and the ground plane.

13. Device according to claim 12, the semiconducting layer (4) forming a ground plane being doped with a dopant concentration greater than 10¹⁹ at.cm⁻³, or greater than 10²⁰ at.cm⁻³.

14. Device according to one of claims 12 or 13, the layer (5) of material acting as a barrier against diffusion being made from Si_{99%}(C)_{1%}.
